# EUROPEAN PATENT SPECIFICATION

(11) **EP 3 955 413 B1**
(45) Date of publication and mention of the grant of the patent: **21.05.2025**
(21) Application number: 20808885.6
(22) Date of filing: 22.05.2020
(51) Int. Cl.: H02J 9/06, G01R 31/3842, H02J 7/00, H02J 9/00, G01R 31/388

(54) **UNINTERRUPTIBLE POWER SUPPLY (UPS), POWER SUPPLY SYSTEM AND BATTERY CAPACITY TEST METHOD**
UNTERBRECHUNGSFREIE STROMVERSORGUNG (USV), STROMVERSORGUNGSSYSTEM UND BATTERIEKAPAZITÄTSTESTVERFAHREN
ALIMENTATION ÉLECTRIQUE SANS INTERRUPTION (UPS), SYSTÈME D'ALIMENTATION ÉLECTRIQUE ET PROCÉDÉ D'ESSAI DE CAPACITÉ DE BATTERIE

(30) Priority: 23.05.2019 CN 201910435165
(43) Date of publication of application: 16.02.2022
(73) Proprietor: Huawei Digital Power Technologies Co., Ltd., Shenzhen, Guangdong 518043 (CN)
(72) Inventor: SHU, Zhou, Shenzhen, Guangdong 518129 (CN)
(74) Representative: Pfenning, Meinig & Partner mbB
(86) International application number: PCT/CN2020/091688
(87) International publication number: WO 2020/233693

(56) References cited:
- EP-A1- 3 148 037
- CN-A- 102 023 283
- CN-A- 103 529 394
- CN-A- 108 808 776
- CN-A- 108 808 776
- CN-A- 110 165 774
- CN-U- 208 571 629
- US-A1- 2003 117 143
- US-A1- 2005 121 979
- US-A1- 2008 306 637
- US-A1- 2015 221 211
- US-A1- 2018 149 709
- US-A1- 2021 098 995

## Description

### TECHNICAL FIELD

This application relates to the power field, and more specifically, to an uninterruptible power supply (UPS), a power supply system, and a battery capacity test method.

### BACKGROUND

An uninterruptible power supply (UPS) system is a system device that connects batteries to a host, and converts a direct current into an alternating current by using a module circuit such as a host inverter. The UPS is mainly configured to provide stable and uninterruptible power supply to a single computer, a computer network system, or another power electronic device such as a solenoid valve or a pressure transmitter. When a mains supply input is normal, the UPS stabilizes mains supply and supplies the mains supply to a load for use. In this case, the UPS is an alternating current voltage regulator, and the UPS may further charge batteries of the UPS. When the mains supply is interrupted (forced outage), the UPS immediately continuously supplies an alternating current to the load by using direct current energy of the batteries and by using the inverter, so that the load normally operates and software and hardware of the load are protected from being damaged.

Because power supply reliability of the system is closely related to battery reliability, the system needs to measure a real-time capacity of the battery online. A solution for performing a battery capacity check test on a storage battery is as follows: All battery packs discharge at the same time, and a discharge depth is generally 100%. In this case, a real-time capacity of the battery in the system can be accurately detected. However, after the battery capacity check test is performed on the battery by using the solution, battery backup time of the UPS power supply system is almost zero, thereby bringing a potential power supply risk to the system.

CN 108 808 776 A discloses that a battery system and a method for detecting a battery health state, the battery system includes a processing module and a plurality of battery modules, each of the plurality of battery modules includes a battery management system and a battery pack.

US 2008/306637 A1 discloses a system and method determines power priority of the subsystems, and selectively distributes power from the battery network system to the subsystems based on the power priority.

US 2005/121979 A1 discloses that the battery packs are connected in parallel and each output thereof is modified to a predetermined voltage by a discharge control section. The battery packs are connected to a power source line of the load device. Each battery pack is connected through an information transmission line to a power source control section where charge and discharge thereof are controlled, as well as the lifetime is judged.

US 2015/221211 A1 discloses that a system may further include test circuitry that is configured to monitor a voltage and an output current of the battery backup when the battery backup is placed under a battery capacity test, and a system controller that is configured to determine, from the monitored voltage and output current of the battery backup, information relating to the capacity of the battery backup.

EP 3 148 037 A1 discloses an energy storage system that includes a battery system, a direct current link, and a controller. The battery system includes battery racks that respectively include rack battery management systems. The battery racks are divided into at least one first battery rack including a first battery and at least one second battery rack including a second battery. The direct current link is connected to the battery system. The controller determines the operation mode of the battery system from one of a charge mode or a discharge mode. The controller performs a control operation in the charge mode to charge the first battery rack and not operate the second battery rack, and performs a control operation in the discharge mode to discharge the second battery rack and not operate the first battery rack.

US 2003/117143 A1 concerns a method of computing remaining battery capacity that computes battery discharge capacity from the integrated value of the product of discharge current and voltage to find remaining battery capacity via energy (integrated power). Battery discharge capacity is computed by adding the integrated value of power consumed by internal resistance to a discharge capacity value calculated from the integrated product of discharge current and voltage, and remaining battery capacity is computed from this battery discharge capacity.

### SUMMARY

The present invention is as defined in the appended set of claims. This application provides an uninterruptible power supply (UPS), a power supply system including the UPS and battery packs, and a battery capacity test method, to accurately detect a total battery capacity of the power supply system, so that during a capacity test and when mains supply is abnormal, battery backup time of the power supply system is sufficient.

According to a first aspect, an uninterruptible power supply (UPS) is provided. The UPS is separately connected to a load and at least two battery packs, and the UPS includes a test unit and a determining unit.

The test unit is configured to: perform a separate capacity test on each battery pack in the at least two battery packs, and obtain a battery capacity of the battery pack, where the separate capacity test includes: measuring the battery capacity of each battery pack when the battery pack and mains supply jointly supply power to the load, where in this case, another battery pack other than the battery pack does not discharge and has backup power. The determining unit is configured to determine a total battery capacity of the at least two battery packs based on the battery capacity of each battery pack.

Therefore, when each battery pack and the mains supply jointly supply power to the load, the battery capacity of the battery pack in a system is detected, and then a total battery capacity of the system is determined based on the battery capacity of each battery pack. In addition, when the battery capacity of each battery pack is detected, the another battery pack other than the detected battery pack does not discharge and has backup power. Based on this, the total battery capacity of the system can be accurately detected, and when a capacity test and the mains supply are abnormal, it can be further ensured that battery backup time of the power supply system is sufficient, thereby reducing a power supply risk of the system.

Further, when the mains supply is abnormal during a time period in which battery discharging and capacity detection are performed, and all the battery packs need to be switched to a battery power supply state, the battery pack that is in a capacity detection state returns to a normal discharging state.

It should be noted that, a battery capacity of a battery pack refers to a real-time capacity of the battery pack, to be specific, in an actual use state, an electric quantity actually discharged by the battery pack after the battery pack is fully charged.

After maintenance personnel learn of a real-time capacity of each battery pack, the maintenance personnel may determine whether the battery backup time of the system is sufficient, and may decide, based on calculated battery backup time of the system, whether the battery pack needs to be replaced, to eliminate a risk caused by insufficient battery backup time of the system.

The UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge. In this way, in this embodiment of this application, the at least two battery packs can be independently controlled by using the at least two control circuits, to charge or discharge, thereby providing a condition for the separate capacity test.

The control circuit includes a DC/DC circuit.

The test unit is further configured to: when performing the separate capacity test on each battery pack, control a discharge voltage of a DC/DC circuit corresponding to the battery pack to be higher than a discharge voltage of a DC/DC circuit corresponding to the another battery pack.

Therefore, the discharge voltage of the DC/DC circuit corresponding to each battery pack is controlled to be higher than the discharge voltage of the DC/DC circuit corresponding to the another battery pack, so that a discharge current of the another battery pack can be 0. In other words, the another battery pack does not discharge.

Further, the test unit is specifically configured to: when performing the separate capacity test on each battery pack, obtain the battery capacity of the battery pack from a DC/DC circuit corresponding to the battery pack. To be specific, in this case, the DC/DC circuit corresponding to each battery pack detects a voltage and a discharge current of the corresponding battery pack, calculates the battery capacity of the battery pack based on the detected voltage and discharge current of the battery pack, and sends the battery capacity of the battery pack to the UPS.

Optionally, the test unit is specifically configured to: when performing the separate capacity test on each battery pack, obtain a voltage and a discharge current of the battery pack, and then determine the battery capacity of the battery pack based on the voltage and the discharge current of the battery pack. In other words, in this case, the UPS is configured to: detect the voltage and the discharge current of each battery pack, and calculate the battery capacity of the battery pack.

Optionally, the test unit is specifically configured to: in a process of performing the separate capacity test on each battery pack, control the battery pack to discharge from a fully charged state to a state in which a battery voltage is a voltage of end of discharge (EOD). In this way, an accurate battery capacity of each battery pack can be obtained, to determine an accurate total battery capacity.

Optionally, the UPS further includes a control unit, configured to: after the battery capacity of each battery pack is obtained, control charging to the battery pack.

In this embodiment of this application, after the separate capacity test is performed on each battery pack, the battery pack is charged. Therefore, it can be ensured that another battery pack is fully charged when the separate capacity test is performed on a next battery pack. In a capacity test process, sufficient battery backup time of the power supply system is ensured, thereby reducing the power supply risk of the system.

According to a second aspect, a power supply system is provided, including the UPS according to the first aspect and any possible implementation of the first aspect, and at least two battery packs connected to the UPS.

The power supply system further includes at least two control circuits connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge.

The control circuit includes a DC/DC circuit.

According to a third aspect, a battery capacity test method is further provided. The method is performed by an uninterruptible power supply (UPS), the UPS is separately connected to a load and at least two battery packs, and the method includes:
performing a separate capacity test on each battery pack in the at least two battery packs, and obtaining a battery capacity of the battery pack, where the separate capacity test includes: measuring the battery capacity of each battery pack when the battery pack and mains supply jointly supply power to the load, where in this case, another battery pack other than the battery pack does not discharge and has backup power; and
determining a total battery capacity of the at least two battery packs based on the battery capacity of each battery pack.

Further, when the mains supply is abnormal during a time period in which battery discharging and capacity detection are performed, and all the battery packs need to be switched to a battery power supply state, the battery pack that is in a capacity detection state returns to a normal discharging state.

The UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge.

The control circuit includes a DC/DC circuit.

The method further includes: when the separate capacity test is performed on each battery pack, controlling a discharge voltage of a DC/DC circuit corresponding to the battery pack to be higher than a discharge voltage of a DC/DC circuit corresponding to the another battery pack.

The obtaining a battery capacity of the battery pack includes:
obtaining the battery capacity of the battery pack from a DC/DC circuit corresponding to the battery pack.

Optionally, the obtaining a battery capacity of the battery pack includes:
obtaining a voltage and a discharge current of the battery pack; and
determining the battery capacity of the battery pack based on the voltage and the discharge current of the battery pack.

Optionally, the method further includes: in a process in which the separate capacity test is performed on each battery pack, controlling the battery pack to discharge from a fully charged state to a state in which a battery voltage is a voltage of end of discharge (EOD).

Optionally, the method further includes: after the battery capacity of each battery pack is obtained, controlling charging to the battery pack.

Therefore, when each battery pack and the mains supply jointly supply power to the load, the battery capacity of the battery pack in a system is detected, and then a total battery capacity of the system is determined based on the battery capacity of each battery pack. In addition, when the battery capacity of each battery pack is detected, the another battery pack other than the detected battery pack does not discharge and has backup power. Based on this, in this embodiment of this application, the total battery capacity of the system can be accurately detected, and when a capacity test and the mains supply are abnormal, it can be further ensured that battery backup time of the power supply system is sufficient, thereby reducing a power supply risk of the system.

### BRIEF DESCRIPTION OF DRAWINGS

FIG. 1 is a schematic diagram of a power supply system according to an embodiment of this application;
FIG. 2 is a schematic diagram of a UPS according to an embodiment of this application;
FIG. 3 is a schematic diagram of a power supply system applying an embodiment of this application;
FIG. 4 is a schematic diagram of a time sequence for battery capacity detection according to an embodiment of this application;
FIG. 5 shows an example of discharge characteristic curves of different DC/DC units;
FIG. 6 shows another example of discharge characteristic curves of different DC/DC units; and
FIG. 7 is a schematic flowchart of a battery capacity test method according to an embodiment of this application.

### DESCRIPTION OF EMBODIMENTS

The following describes technical solutions of this application with reference to accompanying drawings.

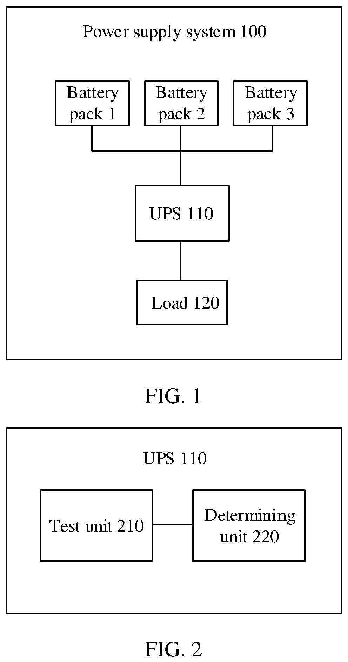

FIG. 1 is a schematic diagram of a power supply system 100 according to an embodiment of this application. The power supply system 100 may be applied to a communication station in the communication field, or may be applied to the field of civilian equipment such as a street lamp system, a property service building, and a vehicle charging station, and is configured to provide stable and uninterruptible power supply. As shown in FIG. 1, the power supply system 100 may include a UPS 110, a load 120, and at least two battery packs (for example, a battery pack 1, a battery pack 2, and a battery pack 3 shown in FIG. 1).

FIG. 2 is a schematic block diagram of the UPS. As shown in FIG. 2, the UPS includes a test unit 210 and a determining unit 220.

The test unit 210 is configured to: perform a separate capacity test on each battery pack in the at least two battery packs, and obtain a battery capacity of the battery pack, where the separate capacity test includes: measuring the battery capacity of each battery pack when the battery pack and mains supply jointly supply power to the load, where in this case, another battery pack other than the battery pack does not discharge and has backup power.

The determining unit 220 is configured to determine a total battery capacity of the at least two battery packs based on the battery capacity of each battery pack.

Therefore, in this embodiment of this application, when each battery pack and the mains supply jointly supply power to the load, the battery capacity of the battery pack in the system is detected, and then a total battery capacity of the system is determined based on the battery capacity of each battery pack. In addition, in this embodiment of this application, when the battery capacity of each battery pack is detected, the another battery pack other than the detected battery pack does not discharge and has backup power. Based on this, in this embodiment of this application, the total battery capacity of the system can be accurately detected, and when a capacity test and the mains supply are abnormal, it can be further ensured that battery backup time of the power supply system is sufficient, thereby reducing a power supply risk of the system.

It should be noted that, in this embodiment of this application, a battery capacity of a battery pack refers to a real-time capacity of the battery pack, to be specific, in an actual use state, an electric quantity actually discharged by the battery pack after the battery pack is fully charged.

After maintenance personnel learn of a real-time capacity of each battery pack, the maintenance personnel may determine whether the battery backup time of the system is sufficient, and may decide, based on calculated battery backup time of the system, whether the battery pack needs to be replaced, to eliminate a risk caused by insufficient battery backup time of the system.

The UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge.

In this way, in this embodiment of this application, the UPS can independently control, by using the at least two control circuits, the at least two battery packs to charge or discharge, thereby providing a condition for the separate capacity test.

The control circuit includes a DC/DC circuit.

When performing the separate capacity test on each battery pack, the test unit 210 controls a discharge voltage of a DC/DC circuit corresponding to the battery pack to be higher than a discharge voltage of a DC/DC circuit corresponding to the another battery pack.

Therefore, the discharge voltage of the DC/DC circuit corresponding to each battery pack is controlled to be higher than the discharge voltage of the DC/DC circuit corresponding to the another battery pack, so that a discharge current of the another battery pack can be 0. In other words, the another battery pack does not discharge.

The test unit 210 is specifically configured to: when performing the separate capacity test on each battery pack, obtain the battery capacity of the battery pack from a DC/DC circuit corresponding to the battery pack. To be specific, in this case, the DC/DC circuit corresponding to each battery pack detects a voltage and a discharge current of the corresponding battery pack, calculates the battery capacity of the battery pack based on the detected voltage and discharge current of the battery pack, and sends the battery capacity of the battery pack to the UPS.

Optionally, when performing the separate capacity test on each battery pack, the test unit 210 obtains a voltage and a discharge current of the battery pack, and then determines the battery capacity of the battery pack based on the voltage and the discharge current of the battery pack. In other words, in this case, the UPS is configured to: detect the voltage and the discharge current of each battery pack, and calculate the battery capacity of the battery pack.

Optionally, the test unit 210 is specifically configured to: in a process of performing the separate capacity test on each battery pack, control the battery pack to discharge from a fully charged state to a state in which a battery voltage is a voltage of end of discharge (EOD). In this way, an accurate battery capacity of each battery pack can be obtained, to determine an accurate total battery capacity.

Optionally, the UPS 110 further includes a control unit, configured to: after the battery capacity of each battery pack is obtained, control charging to the battery pack.

In this embodiment of this application, after the separate capacity test is performed on each battery pack, the battery pack is charged. Therefore, it can be ensured that another battery pack is fully charged when the separate capacity test is performed on a next battery pack. In a capacity test process, sufficient battery backup time of the power supply system is ensured, thereby reducing the power supply risk of the system.

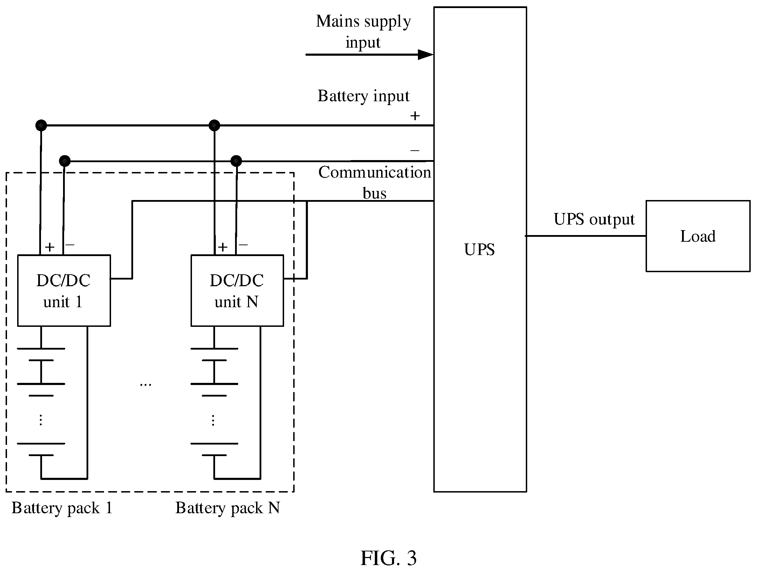

FIG. 3 is a schematic diagram of a power supply system applying an embodiment of this application. As shown in FIG. 3, the power supply system may include a UPS, a load, and a plurality of battery packs. The battery packs include, for example, a battery pack 1 to a battery pack N, where N is an integer greater than 1. When a mains supply input is normal, mains supply provides energy so that the UPS outputs the energy to the load, and the UPS can charge the battery packs. When the mains supply is abnormal, the UPS controls the battery packs to discharge. The battery packs provide energy so that the UPS outputs the energy to the load, and the battery packs are in a discharging state.

In this embodiment of this application, the UPS can further control the mains supply and the battery packs to jointly supply power to the load, that is, a part of energy of the load is provided by the mains supply, and a part of the energy of the load is provided by the battery packs. In this way, all of the mains supply and the battery packs supply power to the system load, thereby providing a precondition for a single battery pack (two battery packs, a plurality of battery packs, or the like) to discharge.

The power supply system further includes direct current to direct current (DC/DC) converter units, and each battery pack is separately connected to the UPS by using the DC/DC unit. For example, the battery pack 1 is connected to the UPS by using a DC/DC unit 1, and the battery pack N is connected to the UPS by using a DC/DC unit N.

Specifically, the DC/DC unit may be an example of the foregoing control circuit. The DC/DC unit may also be referred to as a DC/DC circuit.

In a possible design, the DC/DC unit may be connected to the UPS by using a communication bus, and the communication bus may transmit an instruction or data. As a control module connected to the battery pack, the DC/DC unit may control, under control of the UPS, the battery pack to charge or discharge. Therefore, in this embodiment of this application, the DC/DC unit is disposed on each battery pack, so that the UPS can independently control, by using the DC/DC unit of the battery pack, the battery pack to discharge or charge.

It should be noted that, because each battery pack is separately connected to the UPS by using the DC/DC unit, a charging or discharging state of the battery pack can be independently controlled. In this way, the precondition for a single battery pack (two battery packs, a plurality of battery packs, or the like) to discharge can be provided. Specifically, a discharge current and a discharge voltage of each battery pack may be independently controlled by using the DC/DC unit. For example, the battery pack 1 may discharge, and a battery pack 2 is in a non-charging and non-discharging state.

Optionally, in some embodiments, when the battery pack and the mains supply jointly supply power, a discharge current and a discharge voltage of the discharging battery pack may be separately determined. Then, a battery capacity of the discharging battery pack is determined based on the discharge current and the discharge voltage of the discharging battery pack. As an example, the discharge current may be a discharge current preset by the system and required for detecting a battery capacity.

In some possible implementations, the DC/DC unit may detect voltage information and current information of the battery pack, or the UPS may detect voltage information and current information of the battery pack. This is not limited in this application. Herein, the DC/DC unit and the UPS may be used as examples of the controller 110 in FIG. 1.

Optionally, in this embodiment of this application, after the battery capacity of each battery pack is obtained, the battery pack may be further charged.

In a possible case, when the mains supply normally supplies power, battery discharging and capacity detection are performed in a sequence of the battery pack 1, the battery pack 2, ..., and the battery pack N. After battery discharging and capacity detection are performed on a battery pack, the battery pack may be fully charged, and battery discharging and capacity detection may be then performed on a next battery pack. Real-time battery capacities of all battery packs can be calculated after battery discharging and capacity detection are completed in the sequence of the battery pack 1, the battery pack 2, ..., and the battery pack N.

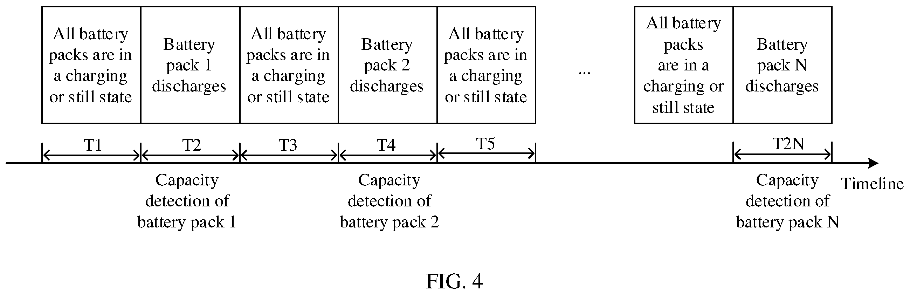

FIG. 4 is a schematic diagram of a time sequence for battery capacity detection according to an embodiment of this application. As shown in FIG. 4, during a time period T1, all the battery packs are in a charging or still state. At the end of the time period T1, all the battery packs are in a fully charged state, to ensure that the battery pack 1 is in the fully charged state before the battery pack 1 is discharged for capacity detection during a time period T2. In addition, it can be ensured that battery backup time of the system is sufficient. The battery pack 1 is discharged for capacity detection during the time period T2, and a real-time battery capacity of the battery pack 1 is calculated. In this case, another battery pack does not supply power to the UPS. During a time period T3, all the battery packs are in the charging or still state, and all the battery packs are in the fully charged state at the end of the time period T3, to ensure that the battery pack 2 is in the fully charged state before the battery pack 2 is discharged for capacity detection during a time period T4. In addition, it can be ensured that the battery backup time of the system is sufficient. The battery pack 2 is discharged for capacity detection during the time period T4, and a real-time battery capacity of the battery pack 2 is calculated. In this case, another battery pack does not supply power to the UPS. By analogy, the rest battery packs are discharged for capacity detection.

In some possible examples, the UPS and/or the DC/DC unit may store the time sequence for battery capacity detection. When the UPS stores the time sequence, there may be data communication between the UPS and each DC/DC unit, and the data communication is used to coordinate a charging and discharging time sequence of the system when battery capacity detection is performed.

In the present invention, when the mains supply is abnormal during a battery self-test period, all the battery packs are switched to a battery discharging state, to ensure uninterruptible power supply of the system.

In a possible manner, when battery discharging and capacity detection are performed on a specific battery pack, another battery pack may also be set to be in a discharging state. However, in this case, a specified value of a discharge voltage of a DC/DC unit of the battery pack on which battery discharging and capacity detection are performed is higher than a specified value of a discharge voltage of a DC/DC unit of the another battery pack. In this way, an output current of a circuit in which the DC/DC unit of the another battery pack is located is 0, and only the DC/DC unit experiencing battery discharging and capacity detection has an actual current that supplies power to the UPS. In other words, only the battery pack can discharge.

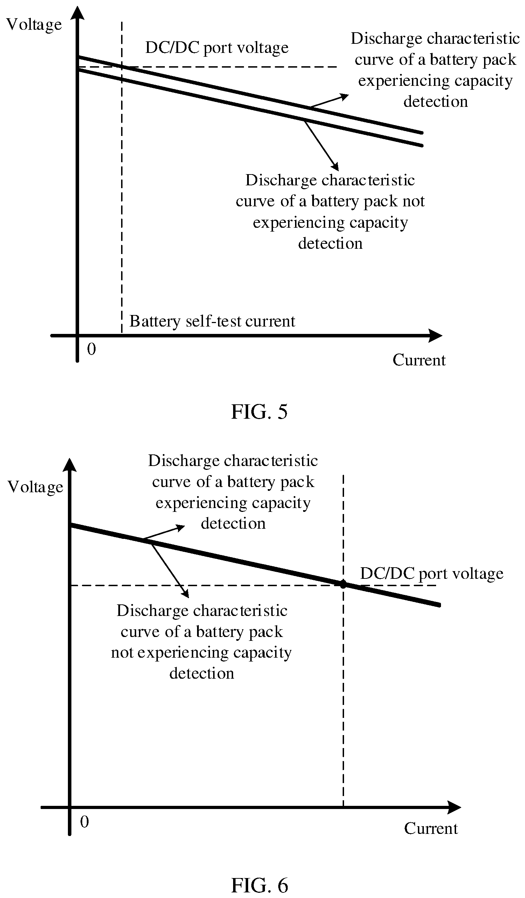

FIG. 5 shows an example of discharge characteristic curves of different DC/DC units when battery discharging and capacity detection are performed on a battery pack. As shown in FIG. 5, a droop algorithm is used for control. A larger output current indicates a lower DC/DC port output voltage. As shown in FIG. 5, in a discharge characteristic curve of a battery pack experiencing capacity detection, when the discharge current is a battery capacity detection current, the DC/DC port output voltage is higher than a highest output voltage in a discharge characteristic curve of a battery pack not experiencing capacity detection. That is, there is no intersecting point between a dashed line representing the DC/DC port voltage and the discharge characteristic curve of the battery pack not experiencing capacity detection. Therefore, a discharge current of the battery pack not experiencing capacity detection is 0.

When the mains supply is abnormal during a time period in which battery discharging and capacity detection are performed, and all the battery packs need to be switched to a battery power supply state, the battery pack that is in a capacity detection state returns to a normal discharging state. As an example, a DC/DC discharge reference voltage corresponding to the battery pack that is in the capacity detection state may be adjusted, and the load is evenly shared by all the battery packs.

FIG. 6 shows an example of discharge characteristic curves of different DC/DC units when the mains supply is abnormal during a time period in which battery discharging and capacity detection are performed. As shown in FIG. 6, a discharge characteristic curve of a battery pack experiencing capacity detection overlaps with a discharge characteristic curve of a battery pack not experiencing capacity detection.

Therefore, in this embodiment of this application, when each battery pack and the mains supply jointly supply power to the load, the battery capacity of the battery pack in the system is detected, and then a total battery capacity of the system is determined based on the battery capacity of each battery pack. In addition, in this embodiment of this application, when the battery capacity of each battery pack is detected, the another battery pack other than the detected battery pack does not discharge and has backup power. Based on this, in this embodiment of this application, the total battery capacity of the system can be accurately detected, and when a capacity test and the mains supply are abnormal, it can be further ensured that battery backup time of the power supply system is sufficient, thereby reducing a power supply risk of the system.

An embodiment of this application further provides a power supply system, including any UPS described above and at least two battery packs connected to the UPS. Optionally, the UPS includes the control circuits described above.

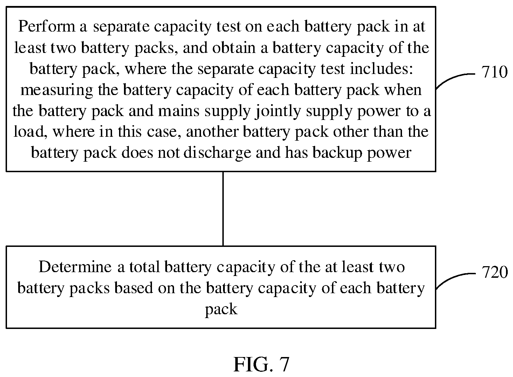

FIG. 7 is a schematic flowchart of a battery capacity test method according to an embodiment of this application. The method should be performed by a UPS, and the UPS is separately connected to a load and at least two battery packs. The method includes the following steps.

710. Perform a separate capacity test on each battery pack in the at least two battery packs, and obtain a battery capacity of the battery pack, where the separate capacity test includes: measuring the battery capacity of each battery pack when the battery pack and mains supply jointly supply power to the load, where in this case, another battery pack other than the battery pack does not discharge and has backup power.

720. Determine a total battery capacity of the at least two battery packs based on the battery capacity of each battery pack.

The UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge.

The control circuit includes a DC/DC circuit.

The method further includes: when the separate capacity test is performed on each battery pack, controlling a discharge voltage of a DC/DC circuit corresponding to the battery pack to be higher than a discharge voltage of a DC/DC circuit corresponding to the another battery pack.

The obtaining a battery capacity of the battery pack includes:
obtaining the battery capacity of the battery pack from a DC/DC circuit corresponding to the battery pack.

Optionally, the obtaining a battery capacity of the battery pack includes:
obtaining a voltage and a discharge current of the battery pack; and
determining the battery capacity of the battery pack based on the voltage and the discharge current of the battery pack.

Optionally, the method further includes: in a process in which the separate capacity test is performed on each battery pack, controlling the battery pack to discharge from a fully charged state to a state in which a battery voltage is a voltage of end of discharge (EOD).

Optionally, the method further includes: after the battery capacity of each battery pack is obtained, controlling charging to the battery pack.

Specifically, for steps shown in FIG. 7, refer to descriptions of the foregoing corresponding apparatus modules. For brevity, details are not described herein again.

Therefore, in this embodiment of this application, when each battery pack and the mains supply jointly supply power to the load, the battery capacity of the battery pack in a system is detected, and then a total battery capacity of the system is determined based on the battery capacity of each battery pack. In addition, in this embodiment of this application, when the battery capacity of each battery pack is detected, the another battery pack other than the detected battery pack does not discharge and has backup power. Based on this, in this embodiment of this application, the total battery capacity of the system can be accurately detected, and when a capacity test and the mains supply are abnormal, it can be further ensured that battery backup time of the power supply system is sufficient, thereby reducing a power supply risk of the system.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application. The foregoing storage medium includes: any medium that can store program code, such as a USB flash drive, a removable hard disk, a read-only memory (ROM), a random access memory (RAM), a magnetic disk, or an optical disc.

## Claims

1. An uninterruptible power supply (110), UPS, wherein the UPS is separately connected to a load (120) and at least two battery packs (1, 2, 3...), the UPS is adapted to control a mains supply and the battery packs to jointly supply power to the load, and the UPS comprises a test unit (210) and a determining unit (220);
the test unit (210) is configured to: perform a separate capacity test on each battery pack in the at least two battery packs, and obtain a battery capacity of the battery pack, wherein the separate capacity test comprises: measuring the battery capacity of each battery pack when the battery pack and the mains supply jointly supply power to the load, wherein in this case, another battery pack other than the battery pack does not discharge and has backup power; and
wherein the UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge; wherein the control circuit comprises a DC/DC circuit; wherein the test unit is further configured to:
when performing the separate capacity test on each battery pack, control a discharge voltage of a DC/DC circuit corresponding to the battery pack to be higher than a discharge voltage of a DC/DC circuit corresponding to the another battery pack;
**characterized in that** the determining unit (220) is configured to determine a total battery capacity of the at least two battery packs based on the battery capacity of each battery pack, and
**in that** the test unit (210) is specifically configured to:
when performing the separate capacity test on each battery pack, obtain the battery capacity of the battery pack from a DC/DC circuit corresponding to the battery pack;
wherein the DC/DC circuit corresponding to each battery pack detects a voltage and a discharge current of the corresponding battery pack, calculates the battery capacity of the battery pack based on the detected voltage and discharge current of the battery pack, and sends the battery capacity of the battery pack to the UPS;
wherein when the mains supply is abnormal during the separate capacity test on each battery pack, all the battery packs are switched to a battery discharging state.

2. The UPS according to claim 1, wherein the test unit (210) is specifically configured to:
in a process of performing the separate capacity test on each battery pack, control the battery pack to discharge from a fully charged state to a state in which a battery voltage is a voltage of end of discharge (EOD).

3. The UPS according to any one of claims 1 to 2, further comprising a control unit, configured to:
after the battery capacity of each battery pack is obtained, control charging to the battery pack.

4. A power supply system (100), comprising the UPS according to any one of claims 1 to 3 and at least two battery packs connected to the UPS.

5. The power supply system according to claim 4, further comprising at least two control circuits connected to the at least two battery packs in a one-to-one correspondence, wherein each control circuit in the at least two control circuits is connected between the UPS and a battery pack corresponding to the control circuit, and the UPS is specifically configured to control, by using each control circuit, a battery pack connected to the control circuit to charge or discharge.

6. The power supply system according to claim 5, wherein the control circuit comprises a DC/DC circuit.

7. The power supply system according to any of the previous claims, wherein switching all the battery packs to a battery discharging state comprises: the battery pack that is in a capacity detection state returns to a normal discharging state and a DC/DC discharge reference voltage corresponding to the battery pack that is in the capacity detection state is adjusted, and the load is evenly shared by all the battery packs.

8. A battery capacity test method, wherein the method is performed by an uninterruptible power supply, UPS, the UPS is separately connected to a load and at least two battery packs, and the UPS is adapted to control mains supply and the battery packs to jointly supply power to the load, and the method comprises:
performing (710) a separate capacity test on each battery pack in the at least two battery packs, and obtaining a battery capacity of the battery pack, wherein the separate capacity test comprises: measuring the battery capacity of each battery pack when the battery pack and mains supply jointly supply power to the load, wherein in this case, another battery pack other than the battery pack does not discharge and has backup power;
wherein the method further comprises:
controlling, by using each control circuit, a battery pack connected to the control circuit to charge or discharge; wherein the control circuit comprises a DC/DC circuit; and the method is **characterized by** determining (720) a total battery capacity of the at least two battery packs based on the battery capacity of each battery pack;
and by, when performing the separate capacity test on each battery pack, controlling a discharge voltage of a DC/DC circuit corresponding to the battery pack to be higher than a discharge voltage of a DC/DC circuit corresponding to the another battery pack; wherein the UPS is further connected to at least two control circuits that are connected to the at least two battery packs in a one-to-one correspondence, each control circuit in the at least two control circuits is connected between the UPS and a battery pack corresponding to the control circuit, and the UPS is specifically configured to control, by using each control circuit, a battery pack connected to the control circuit to charge or discharge;
wherein the UPS is configured to: detect the voltage and the discharge current of each battery pack, and calculate the battery capacity of the battery pack;
wherein the method further comprises: switching all the battery packs are to a battery discharging state when the mains supply is abnormal during the separate capacity test on each battery pack.

9. The method of claim 8,
wherein switching all the battery packs to a battery discharging state comprises: the battery pack that is in a capacity detection state returns to a normal discharging state and a DC/DC discharge reference voltage corresponding to the battery pack that is in the capacity detection state is adjusted, and the load is evenly shared by all the battery packs.

## Patentansprüche

1. Unterbrechungsfreie Leistungsversorgung (110), UPS, wobei die UPS separat mit einer Last (120) und mindestens zwei Batteriepaketen (1, 2, 3...) verbunden ist, die UPS angepasst ist zum Steuern einer Netzversorgung und der Batteriepakete, um der Last gemeinsam Leistung zuzuführen, und die UPS eine Prüfeinheit (210) und eine Bestimmungseinheit (220) umfasst;
die Prüfeinheit (210) konfiguriert ist zum: Durchführen einer separaten Kapazitätsprüfung an jedem Batteriepaket in den mindestens zwei Batteriepaketen und Erlangen einer Batteriekapazität des Batteriepakets, wobei die separate Kapazitätsprüfung umfasst: Messen der Batteriekapazität jedes Batteriepakets, wenn das Batteriepaket und die Netzversorgung der Last gemeinsam Leistung zuzuführen, wobei in diesem Fall ein anderes Batteriepaket als das Batteriepaket sich nicht entlädt und Reserveleistung aufweist; und
wobei die UPS ferner mit mindestens zwei Steuerschaltungen verbunden ist, die mit den mindestens zwei Batteriepaketen in einer Eins-zu-eins-Korrespondenz verbunden sind, jede Steuerschaltung in den mindestens zwei Steuerschaltungen zwischen der UPS und einem Batteriepaket korrespondierend mit der Steuerschaltung verbunden ist und die UPS spezifisch konfiguriert ist zum Steuern, unter Verwendung jeder Steuerschaltung, eines mit der Steuerschaltung verbundenen Batteriepakets zum Laden oder Entladen; wobei die Steuerschaltung eine Gleichstrom/Gleichstrom-Schaltung umfasst; wobei die Prüfeinheit ferner konfiguriert ist zum:
wenn die separate Kapazitätsprüfung an jedem Batteriepaket durchgeführt wird, Steuern einer Entladungsspannung einer Gleichstrom/Gleichstrom-Schaltung korrespondierend mit dem Batteriepaket, höher als eine Entladungsspannung einer Gleichstrom/Gleichstrom-Schaltung korrespondierend mit dem anderen Batteriepaket zu sein;
**dadurch gekennzeichnet, dass** die Bestimmungseinheit (220) konfiguriert ist zum Bestimmen einer gesamten Batteriekapazität der mindestens zwei Batteriepakete basierend auf der Batteriekapazität jedes Batteriepakets, und
dadurch, dass die Prüfeinheit (210) spezifisch konfiguriert ist zum:
wenn die separate Kapazitätsprüfung an jedem Batteriepaket durchgeführt wird, Erlangen der Batteriekapazität des Batteriepakets von einer Gleichstrom/Gleichstrom-Schaltung korrespondierend mit dem Batteriepaket;
wobei die Gleichstrom/Gleichstrom-Schaltung korrespondierend mit jedem Batteriepaket eine Spannung und einen Entladestrom des korrespondierenden Batteriepakets detektiert, die Batteriekapazität des Batteriepakets basierend auf der detektierten Spannung und dem detektierten Entladestrom des Batteriepakets berechnet und die Batteriekapazität des Batteriepakets an die UPS sendet;
wobei, wenn die Netzversorgung während der separaten Kapazitätsprüfung an jedem Batteriepaket abnormal ist, sämtliche der Batteriepakete in einen Batterieentladungszustand geschaltet werden.

2. UPS nach Anspruch 1, wobei die Prüfeinheit (210) spezifisch konfiguriert ist zum:
in einem Prozess des Durchführens der separaten Kapazitätsprüfung an jedem Batteriepaket Steuern des Batteriepakets zum Entladen aus einem vollständig geladenen Zustand in einen Zustand, in dem eine Batteriespannung eine Spannung am Ende der Entladung (EOD) ist.

3. UPS nach einem der Ansprüche 1 bis 2, ferner umfassend eine Steuereinheit, konfiguriert zum:
nachdem die Batteriekapazität jedes Batteriepakets erlangt ist, Steuern des Ladens in das Batteriepaket.

4. Leistungsversorgungssystem (100), umfassend die UPS nach einem der Ansprüche 1 bis 3 und mindestens zwei mit der UPS verbundene Batteriepakete.

5. Leistungsversorgungssystem nach Anspruch 4, ferner umfassend mindestens zwei mit den mindestens zwei Batteriepaketen in einer Eins-zu-eins-Korrespondenz verbundenen Steuerschaltungen, wobei jede Steuerschaltung in den mindestens zwei Steuerschaltungen zwischen der UPS und einem Batteriepaket korrespondierend mit der Steuerschaltung verbunden ist und die UPS spezifisch konfiguriert ist zum Steuern, unter Verwendung jeder Steuerschaltung, eines mit der Steuerschaltung verbundenen Batteriepakets zum Laden oder Entladen.

6. Leistungsversorgungssystem nach Anspruch 5, wobei die Steuerschaltung eine Gleichstrom/Gleichstrom-Schaltung umfasst.

7. Leistungsversorgungssystem nach einem der vorhergehenden Ansprüche, wobei das Schalten sämtlicher der Batteriepakete in einen Batterieentladungszustand umfasst: das Batteriepaket, das in einem Kapazitätsdetektionszustand ist, kehrt in einen normalen Entladungszustand zurück, und eine Gleichstrom/Gleichstrom-Entladungsreferenzspannung korrespondierend mit dem Batteriepaket, das in dem Kapazitätsdetektionszustand ist, wird angepasst und die Last wird auf sämtliche der Batteriepakete gleichmäßig verteilt.

8. Batteriekapazitätsprüfungsverfahren, wobei das Verfahren durch eine unterbrechungsfreie Leistungsversorgung, UPS, durchgeführt wird, die UPS separat mit einer Last und mindestens zwei Batteriepaketen verbunden ist und die UPS angepasst ist zum Steuern einer Netzversorgung und der Batteriepakete, der Last gemeinsam Leistung zuzuführen, und das Verfahren umfasst:
Durchführen (710) einer separaten Kapazitätsprüfung an jedem Batteriepaket in den mindestens zwei Batteriepaketen und Erlangen einer Batteriekapazität des Batteriepakets, wobei die separate Kapazitätsprüfung umfasst: Messen der Batteriekapazität jedes Batteriepakets, wenn das Batteriepaket und die Netzversorgung der Last gemeinsam Leistung zuzuführen, wobei in diesem Fall ein anderes Batteriepaket als das Batteriepaket sich nicht entlädt und Reserveleistung aufweist;
wobei das Verfahren ferner umfasst:
Steuern, unter Verwendung jeder Steuerschaltung, eines mit der Steuerschaltung verbundenen Batteriepakets zum Laden oder Entladen; wobei die Steuerschaltung eine Gleichstrom/Gleichstrom-Schaltung umfasst; und das Verfahren **gekennzeichnet ist durch** Bestimmen (720) einer gesamten Batteriekapazität der mindestens zwei Batteriepakete basierend auf der Batteriekapazität jedes Batteriepakets;
und durch, wenn die separate Kapazitätsprüfung an jedem Batteriepaket durchgeführt wird, Steuern einer Entladungsspannung einer Gleichstrom/Gleichstrom-Schaltung korrespondierend mit dem Batteriepaket, höher als eine Entladungsspannung einer Gleichstrom/Gleichstrom-Schaltung korrespondierend mit dem anderen Batteriepaket zu sein; wobei die UPS ferner mit mindestens zwei Steuerschaltungen verbunden ist, die mit den mindestens zwei Batteriepaketen in einer Eins-zu-eins-Korrespondenz verbunden sind, jede Steuerschaltung in den mindestens zwei Steuerschaltungen zwischen der UPS und einem Batteriepaket korrespondierend mit die Steuerschaltung verbunden ist und die UPS spezifisch konfiguriert ist zum Steuern, unter Verwendung jeder Steuerschaltung, eines mit der Steuerschaltung verbundenen Batteriepakets zum Laden oder Entladen;
wobei die UPS konfiguriert ist zum: Detektieren der Spannung und des Entladestroms jedes Batteriepakets und Berechnen der Batteriekapazität des Batteriepakets;
wobei das Verfahren ferner umfasst: Schalten sämtlicher der Batteriepakete in einen Batterieentladungszustand, wenn die Netzversorgung während der separaten Kapazitätsprüfung an jedem Batteriepaket abnormal ist.

9. Verfahren nach Anspruch 8,
wobei Schalten sämtlicher der Batteriepakete in einen Batterieentladungszustand umfasst: das Batteriepaket, das in einem Kapazitätsdetektionszustand ist, kehrt in einen normalen Entladungszustand zurück, und eine Gleichstrom/Gleichstrom-Entladungsreferenzspannung korrespondierend mit dem Batteriepaket, das in dem Kapazitätsdetektionszustand ist, wird angepasst und die Last wird auf sämtliche der Batteriepakete gleichmäßig verteilt.

## Revendications

1. Alimentation sans interruption (110), ASI, cette ASI étant connectée séparément à une charge (120) et à au moins deux blocs-piles (1, 2, 3...), cette ASI étant adaptée de façon à commander une alimentation secteur et les blocs-piles afin d' alimenter conjointement de l'énergie à la charge, et cette ASI comportant une unité de test (210) et une unité de détermination (220) ;
l'unité de test (210) étant configurée de façon à exécuter un test de capacité séparé sur chaque bloc-piles parmi les au moins deux blocs-piles, et de façon à obtenir une capacité des piles de ce bloc-piles, ce test de capacité séparé comprenant : la mesure de la capacité des piles de chaque bloc-piles lorsque ce bloc-piles et l'alimentation secteur alimentent conjointement de l'énergie à la charge, dans ce cas, un autre bloc-piles différent de ce bloc-piles ne se déchargeant pas et ayant une énergie de secours ; et
cette ASI étant connectée en outre à au moins deux circuits de commande qui sont connectés aux au moins deux blocs-piles selon une correspondance individuelle, chaque circuit de commande parmi les au moins deux circuits de commande étant connecté entre l'ASI et un bloc-piles correspondant à ce circuit de commande, et l'ASI étant configurée spécifiquement de façon à commander, en utilisant chaque circuit de commande, un bloc-piles connecté à ce circuit de commande afin de charger ou de décharger ; le circuit de commande consistant en un circuit CC-CC ; l'unité de test étant configurée en outre de façon à :
lorsqu'elle exécute le test de capacité séparé sur chaque bloc-piles, commander une tension de décharge d'un circuit CC-CC correspondant au bloc-piles pour qu'elle soit plus élevée qu'une tension de décharge d'un circuit CC-CC correspondant à un autre bloc-piles ;
**caractérisée en ce que** l'unité de détermination (220) est configurée de façon à déterminer une capacité totale des piles des au moins deux blocs-piles en se basant sur la capacité des piles de chaque bloc-piles ; et
**en ce que** l'unité de test (210) est configurée spécifiquement de façon à :
lorsqu'elle exécute le test de capacité séparé sur chaque bloc-piles, obtenir la capacité des piles de ce bloc-piles à partir d'un circuit CC-CC correspondant à ce bloc-piles ; le circuit CC-CC correspondant à chaque bloc-piles détectant une tension et un courant de décharge du bloc-piles correspondant, calculant la capacité des piles de ce bloc-piles en se basant sur la tension et sur le courant de décharge détectés de ce bloc-piles, et envoyant la capacité des piles de ce bloc-piles à l'ASI ;
lorsque l'alimentation secteur est anormale pendant le test de capacité séparé sur chaque bloc-piles, tous les blocs-piles étant mis dans un état de décharge des piles.

2. ASI selon la revendication 1, dans laquelle l'unité de test (210) est configurée spécifiquement de façon à :
lors d'un processus d'exécution du test de capacité séparé sur chaque bloc-piles, commander le bloc-piles pour qu'il se décharge depuis un état complètement chargé jusqu'à un état dans lequel une tension des piles est une tension de fin de décharge (EOD).

3. ASI selon l'une quelconque des revendications 1 à 2, comprenant en outre une unité de commande configurée de façon à :
après que la capacité des piles de chaque bloc-piles a été obtenue, commander à ce bloc-piles de se charger.

4. Système d'alimentation électrique (100), comprenant l'ASI selon l'une quelconque des revendications 1 à 3, et au moins deux blocs-piles connectés à cette ASI.

5. Système d'alimentation électrique selon la revendication 4, comprenant en outre au moins deux circuits de commande connectés aux au moins deux blocs-piles selon une correspondance individuelle, chaque circuit de commande parmi les au moins deux circuits de commande étant connecté entre l'ASI et un bloc-piles correspondant à ce circuit de commande, et l'ASI étant configurée spécifiquement de façon à commander, en utilisant chaque circuit de commande, un bloc-piles connecté à ce circuit de commande afin de charger ou de décharger.

6. Système d'alimentation électrique selon la revendication 5, dans lequel le circuit de commande consiste en un circuit CC-CC.

7. Système d'alimentation électrique selon l'une quelconque des revendications précédentes, dans lequel la mise de tous les blocs-piles dans un état de décharge des piles comprend : le bloc-piles qui est dans un état de détection de capacité revient à un état de décharge normal et une tension de référence de décharge CC-CC correspondant au bloc-piles qui est dans l'état de détection de capacité est ajustée, et la charge est partagée également entre tous les blocs-piles.

8. Procédé de test de capacité de piles, ce procédé étant exécuté par une alimentation sans interruption, ASI, cette ASI étant connectée séparément à une charge et à au moins deux blocs-piles, et cette ASI étant adaptée de façon à commander l'alimentation secteur et les blocs-piles afin d'alimenter conjointement de l'énergie à la charge, et ce procédé comprenant :
l'exécution (710) d'un test de capacité séparé sur chaque bloc-piles parmi les au moins deux blocs-piles, et l'obtention d'une capacité des piles de ce bloc-piles, ce test de capacité séparé comprenant : la mesure de la capacité des piles de chaque bloc-piles lorsque ce bloc-piles et l'alimentation secteur alimentent conjointement de l'énergie à la charge, dans ce cas, un autre bloc-piles différent de ce bloc-piles ne se déchargeant pas et ayant une énergie de secours ;
ce procédé comprenant en outre :
la commande, en utilisant chaque circuit de commande, d'un bloc-piles connecté à ce circuit de commande afin de charger ou de décharger ; le circuit de commande consistant en un circuit CC-CC ; et ce procédé étant **caractérisé**
**par** la détermination (720) d'une capacité totale des piles des au moins deux blocs-piles en se basant sur la capacité des piles de chaque bloc-piles ;
et par, lors de l'exécution du test de capacité séparé sur chaque bloc-piles, la commande d'une tension de décharge d'un circuit CC-CC correspondant au bloc-piles pour qu'elle soit plus haute qu'une tension de décharge d'un circuit CC-CC correspondant à un autre bloc-piles ; cette ASI étant connectée en outre à au moins deux circuits de commande qui sont connectés aux au moins deux blocs-piles selon une correspondance individuelle, chaque circuit de commande parmi les au moins deux circuits de commande étant connecté entre l'ASI et un bloc-piles correspondant à ce circuit de commande, et l'ASI étant configurée spécifiquement de façon à commander, en utilisant chaque circuit de commande, un bloc-piles connecté à ce circuit de commande pour charger ou décharger ;
l'ASI étant configurée de façon à détecter la tension et le courant de décharge de chaque bloc-piles, et à calculer la capacité des piles de ce bloc-piles ;
ce procédé comprenant en outre : la mise de tous les blocs-piles dans un état de décharge des piles lorsque l'alimentation secteur est anormale pendant le test de capacité séparé sur chaque bloc-piles.

9. Procédé selon la revendication 8,
dans lequel la mise de tous les blocs-piles dans un état de décharge des piles comprend : le bloc-piles qui est dans un état de détection de capacité revient à un état de décharge normal et une tension de référence de décharge CC-CC correspondant au bloc-piles qui est dans l'état de détection de capacité est ajustée, et la charge est partagée également entre tous les blocs-piles.
